# EUROPÄISCHE PATENTSCHRIFT

(11) **EP 1 066 636 B1**
(45) Veröffentlichungstag und Bekanntmachung des Hinweises auf die Patenterteilung: **22.12.2004**
(21) Anmeldenummer: 99914400.9
(22) Anmeldetag: 03.02.1999
(51) Int. Cl.: G11C 5/14, G11C 16/06

(54) **SYSTEM MIT INTEGRIERTER SCHALTUNG UND SPANNUNGSQUELLEN**
SYSTEM WITH INTEGRATED CIRCUIT AND VOLTAGE SOURCES
SYSTEME AVEC CIRCUIT INTEGRE ET SOURCES DE TENSION

(30) Priorität: 27.02.1998 DE 19808525
(43) Veröffentlichungstag der Anmeldung: 10.01.2001
(73) Patentinhaber: Infineon Technologies AG, 81669 München (DE)
(72) Erfinder: KERN, Thomas, D-80804 München (DE); SOMMER, Dieter, D-82152 Planegg (DE)
(74) Vertreter: Jannig, Peter, Dipl.-Ing.
(86) Internationale Anmeldenummer: PCT/DE1999/000288
(87) Internationale Veröffentlichungsnummer: WO 1999/044203

(56) Entgegenhaltungen:
- EP-A- 0 317 939
- EP-A- 0 356 650
- EP-A- 0 440 204
- EP-A- 0 605 253
- EP-A- 0 686 978
- US-A- 4 365 316

## Beschreibung

Die vorliegende Erfindung betrifft ein System gemäß dem Oberbegriff des Patentanspruchs 1.

Ein solches System ist aus der EP-A-0 440 204 bekannt.

Weitere Druckschriften zu diesem Thema sind die EP-A-0 317 939, die EP-A-0 605 253, die EP-A-0 356 650, die US-A-4 365 316, und die EP-A-0 686 978.

Systeme mit integrierten Schaltungen sind in unzähligen Ausführungsformen bekannt und bedürfen keiner näheren Erläuterung.

Die bekannten integrierten Schaltungen sind äußerst komplexe Gebilde, deren Entwicklung und Herstellung nur wirtschaftlich ist, wenn sie in großen Stückzahlen verkauft werden. Dabei erweist es sich als günstig, wenn sich die integrierten Schaltungen nach deren Herstellung wunschgemäß konfigurieren lassen.

Die Konfigurierbarkeit kann beispielsweise darin bestehen, daß in der integrierten Schaltung enthaltene nichtflüchtige Speicher wie etwa die häufig verwendeten sogenannten OTPs (one time programmable ROMs) individuell mit vorbestimmten Werten beschrieben (programmiert) werden.

Das Programmieren von OTPs und anderen nichtflüchtigen Speichern ist jedoch nicht ganz einfach, weil hierfür relativ hohe Spannungen benötigt werden. Das Bereitstellen dieser hohen Programmierspannungen ist bekanntlich mit einem nicht unerheblichen Aufwand verbunden, so daß die universelle Verwendbarkeit derartiger integrierter Schaltungen mit einem relativ hohen Zusatzaufwand erkauft werden muß.

Der vorliegenden Erfindung liegt daher die Aufgabe zugrunde, ein System mit einer integrierten Schaltung zu schaffen, dessen integrierte Schaltung sich mit minimalem Aufwand individuell konfigurieren läßt.

Diese Aufgabe wird erfindungsgemäß durch das in Patentanspruch 1 beanspruchte System gelöst.

Dadurch können beispielsweise zum Programmieren von Speichern oder Durchbrennen sogenannter Fuses benötigte oder hilfreiche Hochspannungen oder sonstige von der "normalen" Versorgungsspannung abweichende Spannungen einfach von außen an die integrierte Schaltung angelegt werden.

Die von außen zuführbaren Spannungen müssen nicht mehr in der integrierten Schaltung selbst generiert werden, wodurch sich deren Aufbau erheblich vereinfacht.

Vorteilhafte Weiterbildungen der Erfindung sind den Unteransprüchen, der folgenden Beschreibung und den Figuren entnehmbar.

Die Erfindung wird nachfolgend anhand eines Ausführungsbeispiels unter Bezugnahme auf die Figuren näher beschrieben.
Es zeigen
- Figur 1: ein Blockschaltbild eines Ausführungsbeispiels der erfindungsgemäßen integrierten Schaltung,
- Figur 2: eine Möglichkeit der praktischen Realisierung der Versorgungsspannungs-Umschaltvorrichtung gemäß Figur 1,
- Figur 3: Spannungsverläufe an den Ein- und Ausgängen der Versorgungsspannungs-Umschaltvorrichtung gemäß Figur 2,
- Figur 4: eine Möglichkeit der praktischen Realisierung einer HVNAND-Einheit der Versorgungsspannungs-Umschaltvorrichtung gemäß Figur 2,
- Figur 5: eine Möglichkeit der praktischen Realisierung einer HVON-Einheit der Versorgungsspannungs-Umschaltvorrichtung gemäß Figur 2, und
- Figur 6: den Verlauf des Ausgangssignals der HVON-Einheit gemäß Figur 5 in Abhängigkeit von der Größe der zweiten Versorgungsspannung.

Die nachfolgend näher beschriebene integrierte Schaltung ist zum gleichzeitigen Anlegen zweier verschieden hoher Versorgungsspannungen ausgelegt und weist eine Versorgungsspannungs-Umschaltvorrichtung auf, über welche ausgewählten Teilen der integrierten Schaltung wahlweise die erste Versorgungsspannung oder die zweite Versorgungsspannung zuführbar ist.

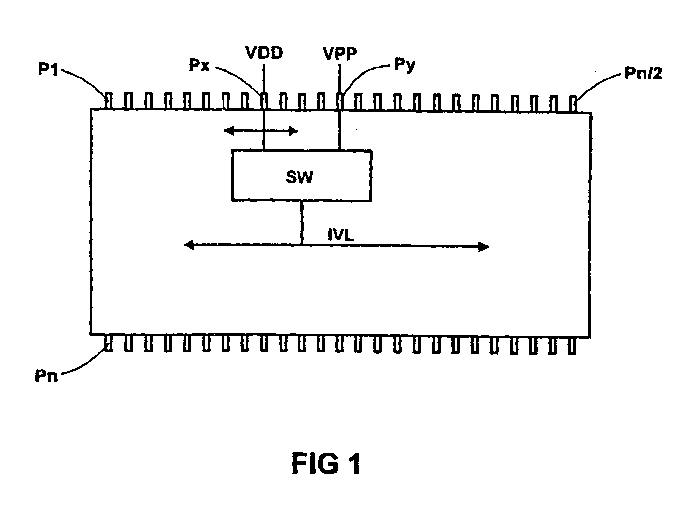

Der Aufbau einer solchen integrierten Schaltung ist schematisch in Figur 1 dargestellt. Sie weist eine Vielzahl von Anschluß-Pins P1 bis Pn auf von welchen ein mit Px bezeichneter Anschluß-Pin zum Anlegen einer ersten Versorgungsspannung, und ein mit Py bezeichneter Anschluß-Pin zum Anlegen einer zweiten Versorgungsspannung ausgelegt ist.

Die erste Versorgungsspannung ist im betrachteten Beispiel die "normale" Versorgungsspannung VDD von beispielsweise 5 V; die zweite Versorgungsspannung ist im betrachteten Beispiel eine Hochspannung VPP von beispielsweise 12 V zum Programmieren von in der integrierten Schaltung enthaltenen OTPs. Es sei bereits an dieser Stelle darauf hingewiesen, daß die an die integrierte Schaltung angelegten Versorgungsspannungen auch beliebig höher und/oder niedriger sein können und auch für beliebige andere Zwecke als die genannten vorgesehen sein können. Darüber hinaus wäre es auch denkbar, die integrierte Schaltung zum Anlegen von mehr als zwei Versorgungsspannungen auszulegen und wahlweise eine dieser mehreren Spannungen zu verwenden.

Im betrachteten Beispiel liegt die erste Versorgungsspannung VDD ständig an der integrierten Schaltung an, wohingegen die zweite Versorgungsspannung VPP "nur" bei Bedarf zusätzlich angelegt wird. Der Anschluß-Pin Px, an welchen die erste Versorgungsspannung VDD angelegt wird, ist ein ausschließlich zum Anlegen der ersten Versorgungsspannung ausgelegter Anschluß-Pin, wohingegen der Anschluß-Pin Py, an welchen die zweite Versorgungsspannung VPP angelegt wird, ein Anschluß-Pin ist, der auch für andere Zwecke als zum Anlegen einer Versorgungsspannung verwendbar ist und nur dann, wenn die zweite Versorgungsspannung VPP benötigt wird, als Versorgungsspannungsanschluß verwendet wird; der Anschluß-Pin Py ist mithin ein Multifunktions-Anschluß-Pin. Es dürfte einleuchten, daß auch hierauf keine Einschränkung besteht und die jeweiligen Versorgungsspannungen grundsätzlich unabhängig voneinander zu beliebigen Zeiten, beliebig lange, und an beliebige Anschluß-Pins angelegt werden können.

Die erste Versorgungsspannung und die zweite Versorgungsspannung werden an eine Versorgungsspannungs-Umschaltvorrichtung SW angelegt, welche in Abhängigkeit von gewissen Kriterien wahlweise die erste Versorgungsspannung oder die zweite Versorgungsspannung ausgibt. Die von der Versorgungsspannungs-Umschaltvorrichtung SW ausgegebene Spannung wird auf eine interne Versorgungsleitung IVL gegeben und über diese den Schaltungsteilen (beispielsweise den OTPs) zugeführt, die abhängig von deren Verwendung, deren Betriebsart oder sonstigen Bedingungen entweder die erste Versorgungsspannung oder die zweite Versorgungsspannung benötigen.

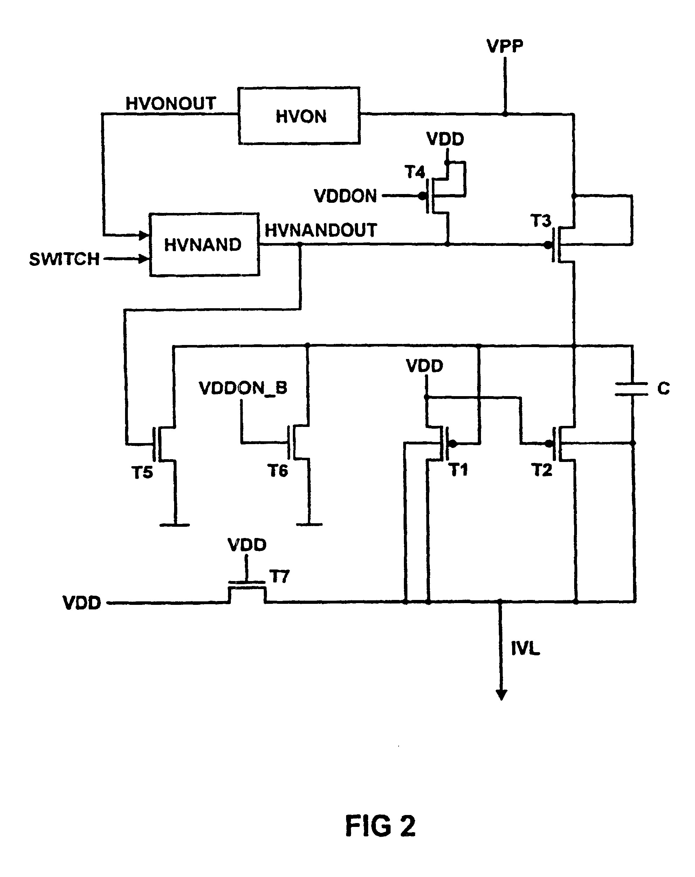

Eine mögliche praktische Realisierung der Versorgungsspannungs-Umschaltvorrichtung SW ist in Figur 2 gezeigt.

Die in der Figur 2 gezeigte Versorgungsspannungs-Umschaltvorrichtung umfaßt PMOS-Transistoren T1 bis T4, NMOS-Transistoren T5 bis T7, einen Kondensator C, eine HVON-Einheit HVON und eine HVNAND-Einheit HVNAND, die wie gezeigt verschaltet sind; die genannten Bestandteile der Versorgungsspannungs-Umschaltvorrichtung sind, obgleich dies nur teilweise explizit erwähnt ist, z.T. für Hochspannungen ausgelegt.

Den Kern der Versorgungsspannungs-Umschaltvorrichtung bilden die Transistoren T1 und T2, von welchen der eine (der Transistor T1) sourceseitig mit der ersten Versorgungsspannung VDD und gateseitig mit der zweiten Versorgungsspannung VPP beaufschlagt ist, und von welchen der andere (der Transistor T2) sourceseitig mit der zweiten Versorgungsspannung VPP und gateseitig mit der ersten Versorgungsspannung VDD beaufschlagt ist, wobei die zweite Versorgungsspannung VPP über den Transistor T3 zugeführt wird. Infolge der Kreuzkopplung der Transistoren T1 und T2 schalten diese jeweils die höhere der anliegenden Sourcespannungen auf die mit den Drainanschlüssen verbundene interne Versorgungsleitung IVL durch; d.h., der Transistor mit der höheren Sourcespannung schaltet jeweils durch, und der Transistor mit der niedrigeren Sourcespannung sperrt jeweils.

Durch den Transistor T3, dessen Funktion und Wirkungsweise später noch genauer beschrieben wird, wird bewirkt, daß die zweite Versorgungsspannung VPP nur dann zu dem soeben erwähnten Transistorpaar durchgeschaltet wird, wenn und so lange sie um einen bestimmten Betrag (im betrachteten Beispiel um ca. 3 V) höher ist als die erste Versorgungsspannung VDD.

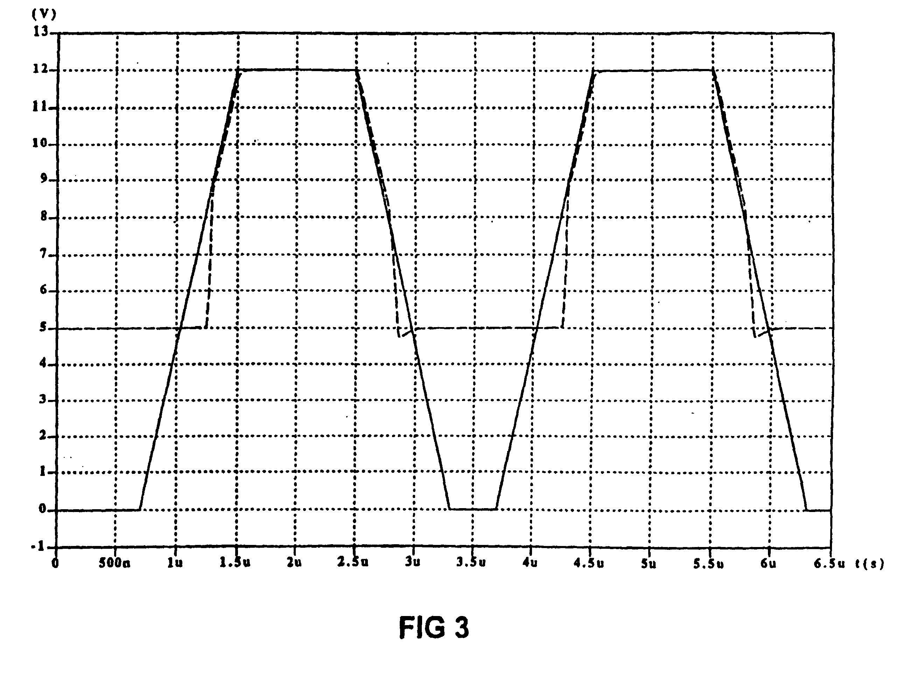

Im Ergebnis stellt sich dadurch auf der internen Versorgungsleitung IVL ein Spannungsverlauf ein wie er in Figur 3 gezeigt ist.

Von den in der Figur 3 gezeigten Spannungsverläufen zeigt die durchgezogen dargestellte Kurve den Verlauf der an den Anschluß-Pin Py angelegten zweiten Versorgungsspannung VPP, und die gestrichelt dargestellte Kurve den Spannungsverlauf auf der internen Versorgungsleitung IVL.

Wie aus der Figur 3 ersichtlich ist, wird die interne Versorgungsleitung IVL mit der ersten Versorgungsspannung VDD (= 5 V) beaufschlagt, wenn und so lange die zweite Versorgungsspannung kleiner als ca. 8 V (= VDD + 3 V) ist; in dieser Phase ist nämlich die am Sourceanschluß des Transistors T1 anliegende Spannung (VDD) größer als die am Sourceanschluß des Transistors T2 anliegende Spannung (0 V, weil der Transistor T3 noch sperrt), wodurch der Transistor T1 leitet (und damit die erste Versorgungsspannung VDD durchschaltet), und der Transistor T2 sperrt. Sobald die zweite Versorgungsspannung VPP ca. 8 V erreicht hat, wird diese auf die interne Versorgungsleitung IVL geschaltet; in dieser Phase ist nämlich die am Sourceanschluß des Transistors T2 anliegende Spannung (VPP, weil der Transistor jetzt leitet) größer als die am Sourceanschluß des Transistors T1 anliegende Spannung (VDD), wodurch der Transistor T2 leitet (und damit die zweite Versorgungsspannung VPP durchschaltet), und der Transistor T1 sperrt. Wenn die zweite Versorgungsspannung VPP auf die interne Versorgungsleitung durchgeschaltet ist, folgt die Spannung auf der internen Versorgungsleitung IVL der zweiten Versorgungsspannung VPP. Die zweite Versorgungsspannung VPP wird allerdings nur auf die interne Versorgungsleitung geschaltet, wenn und so lange die zweite Versorgungsspannung VPP größer als 8 V ist. Fällt die zweite Versorgungsspannung VPP unter diesen Wert ab, so wird sie vom Transistor T3 nicht mehr zum Transistorpaar durchgeschaltet, wodurch die Sourcespannung des Transistors T1 (VDD) wieder größer wird als die Sourcespannung des Transistors T2 und folglich wieder die erste Versorgungsspannung VDD auf die interne Versorgungsleitung geschaltet wird.

Daß der Transistor T3 die zweite Versorgungsspannung VPP erst durchschaltet, wenn und so lange diese um einen vorbestimmten Betrag größer ist als die erste Versorgungsspannung VDD, wird durch die bereits erwähnten HVON-Einheit HVON und die HVNAND-Einheit HVNAND bewirkt. Der Transistor T3 wird durch das Ausgangssignal HVNANDOUT der HVNAND-Einheit HVNAND gesteuert, welches seinerseits wiederum vom Ausgangssignal HVONOUT der HVON-Einheit HVON abhängt.

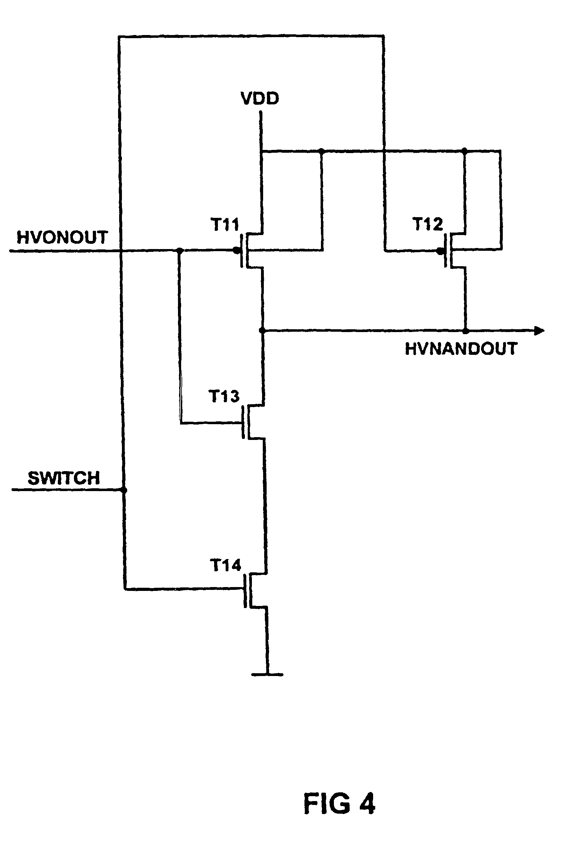

Die HVNAND-Einheit entspricht funktional einem logischen NAND-Gatter; besonders daran ist "nur", daß es teilweise für Hochspannungen ausgelegt ist. Eine mögliche praktische Realisierung der HVNAND-Einheit ist in Figur 4 dargestellt.

Wie aus der Figur 4 ersichtlich ist, besteht die dort gezeigte HVNAND-Einheit aus PMOS-Transistoren T11 und T12 und NMOS-Transistoren T13 und T14, die wie gezeigt verschaltet sind.

In die HVNAND-Einheit HVNAND werden zwei Signale, nämlich das Ausgangssignal HVONOUT der HVON-Einheit HVON und ein Steuersignal SWITCH eingegeben. Durch das Steuersignal SWITCH wird der HVNAND-Einheit HVNAND signalisiert, ob der Anschluß-Pin Py, an welchen die zweite Versorgungsspannung VPP anzulegen ist, als Versorgungsspannungs-Pin oder als "normaler" Pin mit anderer Funktion verwendet wird. Wird er als Versorgungsspannungs-Pin verwendet (ist das dort angelegte Signal also als zweite Versorgungsspannung VPP zu interpretieren), so wird das Steuersignal SWITCH auf 1 gesetzt; anderenfalls hat es den Wert 0.

Wenn sowohl das Steuersignal SWITCH als auch das Ausgangssignal HVONOUT der HVON-Einheit gleich 1 sind, wird das Ausgangssignal HVNANDOUT der HVNAND-Einheit gleich 0, wodurch der Transistor T3 zum Durchschalten der zweiten Versorgungsspannung VPP veranlaßt wird.

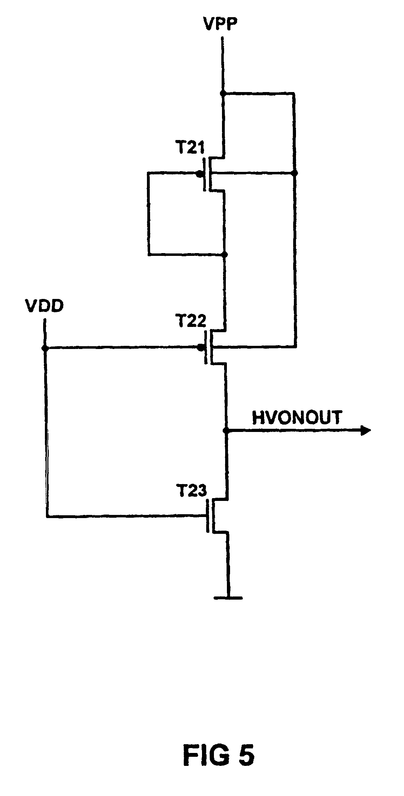

Die HVON-Einheit HVON detektiert, ob die eingegebene zweite Versorgungsspannung VPP größer als VDD + 3 V ist. Eine möglich praktische Realisierung der HVON-Einheit HVON ist in Fig. 5 gezeigt.

Wie aus der Figur 5 ersichtlich ist, besteht die HVON-Einheit HVON aus PMOS-Transistoren T21 und T22 und einem NMOS-Transistor T23, die wie gezeigt verschaltet sind.

Die HVON-Einheit erhält die zweite Versorgungsspannung VPP als Eingangssignal und gibt das bereits erwähnte Ausgangssignal HVONOUT aus.

Ist die zweite Versorgungsspannung VPP in etwa gleich der ersten Versorgungsspannung VDD, so ist das aus den Transistoren T21 und T22 bestehende Transistorpaar sperrend und der Transistor T23 leitend, wodurch der Knotenpunkt, von welchem das Ausgangssignal HVONOUT abgegriffen wird, über den Transistor T23 mit Masse verbunden ist. Wenn die zweite Versorgungsspannung VPP ansteigt und die Summe aus der ersten Versorgungsspannung VDD und den Einsatz- bzw. Thresholdspannungen der Transistoren T21 und T22 erreicht, werden die beiden Transistoren T21 und T22 leitend, wodurch der Knotenpunkt, von welchem das Ausgangssignal HVONOUT abgegriffen wird, geladen wird. Beim weiteren Anstieg der zweiten Versorgungsspannung VPP werden die Transistoren T21 und T22 immer niederohmiger, wodurch das Ausgangssignal HVONOUT der HVON-Einheit schließlich in Richtung zweiter Versorgungsspannung VPP kippt. Das Ausgangssignal HVONOUT der HVON-Einheit erreicht dabei jedoch maximal einen Wert, der um die Summe der Einsatz- bzw. Thresholdspannungen der Transistoren T21 und T22 unter der zweiten Versorgungsspannung VPP liegt.

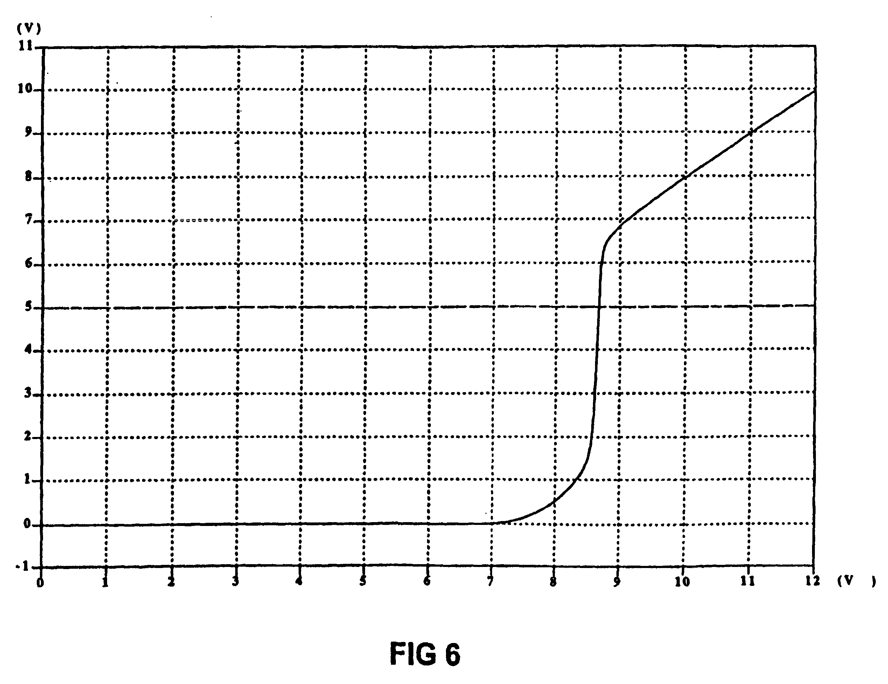

Der Verlauf der Spannung des Ausgangssignals HVONOUT in Abhängigkeit von der Höhe der zweiten Versorgungsspannung VPP ist in Figur 6 veranschaulicht, wobei die Spannung des Ausgangssignals HVONOUT auf der vertikalen Achse und die Höhe der zweiten Versorgungsspannung VPP auf der horizontalen Achse aufgetragen ist.

Durch wie beschrieben oder ähnlich aufgebaute Versorgungsspannungs-Umschaltvorrichtungen kann die interne Versorgungsleitung IVL automatisch wahlweise mit der ersten Versorgungsspannung VDD oder der zweiten Versorgungsspannung VPP beaufschlagt werden. Ob die erste Versorgungsspannung VDD oder die zweite Versorgungsspannung VPP auf die interne Versorgungsleitung gegeben wird, hängt dabei im wesentlichen ausschließlich von der Größe der zweiten Versorgungsspannung ab. Die verwendeten Steuersignale, d.h. die noch nicht erwähnten Steuersignale VDDON und VDDON_B, welche übrigens das Einschalten der ersten Versorgungsspannung VDD signalisieren, und das bereits genannte Steuersignal SWITCH werden "nur" zur Vermeidung undefinierter Zustände verwendet und können durch die integrierte Schaltung auf einfache Weise intern selbst erzeugt werden, beispielsweise durch deren Poweron-Detect-Schaltung (VDDON und VDDON_B) bzw. eine Betriebsartwahleinrichtung (SWITCH). Das Verhindern undefinierter Zustände ist übrigens auch der Grund für das Vorsehen der Schaltungsteile, die zwar in den Figuren gezeigt, aber nicht explizit beschrieben sind (deren Funktion ist leicht nachvollziehbar und bedarf keiner gesonderten Erläuterung).

Damit die Versorgungsspannungs-Umschaltvorrichtung unter allen Umständen ordnungsgemäß arbeitet, werden vorzugsweise auch spezielle Maßnahmen vorgesehen, durch die verhinderbar ist, daß pn-Übergänge vorübergehend oder dauerhaft in Flußrichtung gepolt sind.

Die erste der genannten Maßnahmen besteht darin, daß die Wannen der Transistoren T1 und T2 auf die jeweiligen Drain-Potentiale gelegt werden. Damit kann unter allen Umständen, d.h. auch dann, wenn der Anschluß-Pin Py nicht mit der zweiten Versorgungsspannung VPP beaufschlagt wird, sondern als "normaler" Pin verwendet wird, an welchen Logikspannungen von beispielsweise 0 und 5 V angelegt werden, verhindert werden, daß sich im stationären Betrieb in Flußrichtung gepolte pn-Übergänge ausbilden.

Durch Vorsehen weiterer Maßnahmen kann erreicht werden, daß auch durch transiente Vorgänge, genauer gesagt durch den Anstieg und/oder den Abfall der ersten Versorgungsspannung VDD und/oder der zweiten Versorgungsspannung VPP verursachte temporäre Flußpolungen verhindert werden.

Ein Anstieg der zweiten Versorgungsspannung VPP tritt unter anderem beim Anlegen derselben an den Anschluß-Pin Py auf. Damit dieser Anstieg keine Probleme bereiten kann, wurden beim vorliegend betrachteten Beispiel Vorkehrungen getroffen, um eine mögliche Polung der sogenannten Source/Bulk-Diode des Transistors T2 in Flußrichtung und/oder den über die Source/Bulk-Diode fließende Bulkstrom zeit- und/oder größenmäßig zu minimieren.

Die Polung der Source/Bulk-Diode des Transistors T2 in Flußrichtung kann nach dem Überschreiten der Schaltschwelle der HVON-Einheit HVON (wenn VPP etwa 8 V erreicht hat) auftreten. Dann steigt nämlich die Spannung der internen Versorgungsleitung IVL und damit auch das Potential der den Transistor T2 enthaltenden Wanne von VDD (die interne Versorgungsleitung IVL ist auf VDD vorgeladen) auf VPP an. Der über die Source/Bulk-Diode Bulkstrom wurde im betrachteten Beispiel hinsichtlich dessen Größe und dessen zeitlicher Dauer reduziert.

Zur Reduzierung des Bulkstromes wird der dem Transistor T2 vorgeschaltete Transistor T3 vorzugsweise relativ hochohmig gewählt. Dadurch erhöht sich zwar die Ladezeit der Lastkapazitäten, doch ist dies im allgemeinen ohne weiteres tolerierbar, denn das Bringen der internen Versorgungsleitung auf die zweite Versorgungsspannung VPP wird in der Regel ja nicht zeitkritisch sein.

Zur Reduzierung der Dauer der Flußpolung der Source/Bulk-Diode gibt es zwei Möglichkeiten. Zum Verständnis der vorgeschlagenen Maßnahmen ist wichtig zu wissen, daß sich eine Polung der Source/Bulk-Diode in Flußrichtung nur einstellen kann, wenn und so lange der Transistor T2 noch nicht aktiv ist; sobald der MOS-Teil des Transistors T2 aktiv wird, bildet dieser einen Nebenschluß zur Source/Bulk-Diode. Kritisch ist also nur die Phase, während welcher die am Sourceanschluß des Transistors T2 anliegende Spannung zwischen der ersten Versorgungsspannung VDD und der Summe aus der ersten Versorgungsspannung VDD und der Einsatz- bzw. Thresholdspannung des Transistors T2 liegt. Diese kritische Phase läßt sich verkürzen, indem für den Transistor T2 ein Halbleitermaterial verwendet wird, bei welchem die sogenannte Schleusenspannung besonders hoch ist; über die Source/Bulk-Diode kann nämlich erst dann ein nennenswerter Strom fließen, wenn die am Sourceanschluß des Transistors T2 anliegende Spannung um die besagte Schleusenspannung größer als die erste Versorgungsspannung VDD ist. Zusätzlich oder alternativ kann vorgesehen werden, zwischen dem Sourceanschluß und dem Drainanschluß des Transistors eine zusätzliche Kapazität (den Kondensator C gemäß Figur 2) vorzusehen. Diese Kapazität (im betrachteten Beispiel 30 pF) dient als Pumpkapazität, um die interne Versorgungsleitung auf ein höheres Potential zu schieben, wenn und so lange der Transistor T2 noch nicht aktiv ist. Wenn die Pumpwirkung genügend gut ist, d.h. die dadurch bewirkte Spannungserhöhung auf der internen Versorgungsleitung genügend hoch ist, schaltet der Transistor T2 durch, bevor die Source/Bulk-Diode wirksam werden kann. Die Pumpkapazität wird vorzugsweise an die Lastkapazität der internen Versorgungsleitung angepaßt. Dadurch kann die erzielbare Pumpwirkung maximiert werden.

Auf die beschriebene Art und Weise kann sichergestellt werden, daß das bislang noch nicht praktizierte Anlegen einer zweiten Versorgungsspannung VPP an die integrierte Schaltung keine oder jedenfalls keine ernsthafte Probleme bereitet.

Es kann sich auch als vorteilhaft erweisen, wenn darüber hinaus Maßnahmen ergriffen werden, durch die verhinderbar ist, daß durch den Anstieg der ersten Versorgungsspannung VDD eine Polung der Source/Bulk-Diode des Transistors T1 in Flußrichtung bewirkt wird. Ein Anstieg der ersten Versorgungsspannung VDD tritt unter anderem beim Anlegen derselben an den Anschluß-Pin Px auf. Die Polung der Source/Bulk-Diode des Transistors T1 in Flußrichtung läßt sich verhindern, wenn parallel zur Source/Bulk-Diode ein sogenannter NIMOS eingefügt wird, welcher bei der Herstellung von EPROMs ohne Verwendung zusätzlicher Masken, also denkbar einfach und kostengünstig realisiert werden kann. Der besagte NIMOS weist bekanntlich eine sehr geringe Einsatzspannung auf (etwa 0,2 - 0,3 V), wodurch die Source/Bulk-Diode lange vor dem Fließen eines nennenswerten Bulkstromes kurzgeschlossen und mithin nicht mehr in Flußrichtung gepolt werden kann.

Damit kann sichergestellt werden, daß auch das Anlegen der ersten Versorgungsspannung VDD an die integrierte Schaltung keine Probleme bereiten kann.

Die beschriebene integrierte Schaltung läßt sich folglich unter allen Umständen mit minimalem Aufwand schnell und sicher individuell konfigurieren.

## Patentansprüche

1. System bestehend aus einer integrierten Schaltung, einer eine erste Versorgungsspannung (VDD) abgebenden Einrichtung, und einer eine zweite Versorgungsspannung (VPP) abgebenden Einrichtung,
- wobei die integrierte Schaltung
- einen zum Anlegen der ersten Versorgungsspannung (VDD) vorgesehenen ersten Pin (Px) aufweist,
- einen zum Anlegen der zweiten Versorgungsspannung (VPP) vorgesehenen zweiten Pin (Py) aufweist, und
- eine Versorgungsspannungs-Umschaltvorrichtung (SW) aufweist, über welche bestimmten Teilen, und zwar nur bestimmten Teilen der integrierten Schaltung wahlweise die erste Versorgungsspannung (VDD) oder die zweite Versorgungsspannung (VPP) zuführbar ist,
**dadurch gekennzeichnet,**
- **daß** die erste Versorgungsspannung (VDD) die normale Versorgungsspannung ist, die der integrierten Schaltung während des normalen Betriebes derselben ständig zugeführt wird,
- **daß** die zweite Versorgungsspannung (VPP) eine Versorgungsspannung ist, die größer ist als die erste Versorgungsspannung (VDD), und nur zeitweise zusätzlich zur ersten Versorgungsspannung (VDD) angelegt wird, und
- **daß** die Versorgungsspannungs-Umschaltvorrichtung (SW) dazu ausgelegt ist, automatisch die zweite Versorgungsspannung (VPP) durchzuschalten, wenn und so lange diese um einen bestimmten Mindestbetrag größer ist als die erste Versorgungsspannung (VDD).

2. System nach Anspruch 1,
**dadurch gekennzeichnet,**
**daß** die integrierte Schaltung zum Anlegen der zweiten Versorgungsspannung (VPP) einen Multifunktions-Anschluß-Pin (Py) aufweist, der, wenn und so lange keine zweite Versorgungsspannung angelegt wird, zum Ein- und/oder Ausgeben anderer Signale verwendbar ist.

3. System nach einem der vorhergehenden Ansprüche,
**dadurch gekennzeichnet,**
**daß** die Versorgungsspannungs-Umschaltvorrichtung (SW) ein kreuzgekoppeltes Transistorpaar (T1, T2) enthält, von dessen Transistoren derjenige Transistor, der sourceseitig mit der höheren Spannung beaufschlagt ist, diese höhere Spannung durchschaltet, und derjenige Transistor, der sourceseitig mit der niedrigeren Spannung beaufschlagt ist, sperrt.

4. System nach Anspruch 3,
**dadurch gekennzeichnet,**
**daß** der eine Transistor (T1) des Transistorpaares (T1, T2) sourceseitig mit der ersten Versorgungsspannung (VDD) und gateseitig mit der zweiten Versorgungsspannung (VPP) beaufschlagt ist, und daß der zweite Transistor (T2) des Transistorpaares (T1, T2) sourceseitig mit der zweiten Versorgungsspannung (VPP) und gateseitig mit der ersten Versorgungsspannung (VDD) beaufschlagt ist.

5. System nach Anspruch 4,
**dadurch gekennzeichnet,**
**daß** die Versorgungsspannungs-Umschaltvorrichtung (SW) dazu ausgelegt ist, die Transistoren des Transistorpaares (T1, T2) nur dann mit der zweiten Versorgungsspannung (VPP) zu beaufschlagen, wenn und so lange am Multifunktions-Anschluß-Pin (Py) tatsächlich eine Versorgungsspannung anliegt und diese um einen bestimmten Mindestbetrag größer ist als die erste Versorgungsspannung (VDD).

6. System nach einem der Ansprüche 3 bis 5,
**dadurch gekennzeichnet,**
**daß** die die Transistoren des Transistorpaares (T1, T2) enthaltenden Wannen auf das Drainpotential der jeweiligen Transistoren gelegt sind.

7. System nach einem der Ansprüche 3 bis 6,
**dadurch gekennzeichnet,**
**daß** zwischen dem Source- und Drainanschluß des zweiten Transistors (T2) des Transistorpaares (T1, T2) ein Kondensator (C) vorgesehen ist.

8. System nach einem der Ansprüche 3 bis 7,
**dadurch gekennzeichnet,**
**daß** parallel zur Source/Bulk-Diode des ersten Transistors (T1) des Transistorpaares (T1, T2) ein NIMOS vorgesehen ist.

9. System nach einem der vorhergehenden Ansprüche,
**dadurch gekennzeichnet,**
**daß** die ausgewählten Schaltungsteile, denen wahlweise die erste Versorgungsspannung (VDD) oder die zweite Versorgungsspannung (VPP) zuführbar ist, einen programmierbaren Speicher umfassen, der unter Verwendung der ersten Versorgungsspannung auslesbar und unter Verwendung der zweiten Versorgungsspannung programmierbar ist.

## Claims

1. System comprising an integrated circuit, a device outputting a first supply voltage (VDD) and a device outputting a second supply voltage (VPP),
- the integrated circuit comprising
- a first pin (Px) for applying the first supply voltage (VDD)
- a second pin (Py) for applying the second supply voltage (VPP), and
- a supply-voltage switchover device (SW) via which optionally the first supply voltage (VDD) or the second supply voltage (VPP) can be supplied to certain parts, in fact only to certain parts of the integrated circuit,
**characterized in that**
- the first supply voltage (VDD) is the normal supply voltage that is supplied to the integrated circuit during the normal operation of said integrated circuit,
- the second supply voltage (VPP) is a supply voltage that is greater than the first supply voltage (VDD) and is applied only occasionally in addition to the first supply voltage (VDD), and
- the supply-voltage switchover device (SW) is designed to switch through the second supply voltage (VPP) automatically when and as long as it is greater than the first supply voltage (VDD) by a certain minimum amount.

2. System according to Claim 1,
**characterized in that**
the integrated circuit comprises a multifunction connection pin (Py) for applying the second supply voltage (VPP), which can be used for the input and/or output of other signals when and as long as no second supply voltage is applied.

3. System according to one of the preceding claims,
**characterized in that**
the supply-voltage switchover device (SW) contains a crosscoupled transistor pair (T1, T2), of whose transistors, that transistor to whose source the higher voltage is applied, switches through this higher voltage, and that transistor to whose source the lower voltage is applied, is cut off.

4. System according to Claim 3,
**characterized in that**
the first supply voltage (VDD) is applied to the source, and the second supply voltage (VPP) is applied to the gate, of the one transistor (T1) of the transistor pair (T1, T2), and that the second supply voltage (VPP) is applied to the source, and the first supply voltage (VDD) is applied to the gate, of the second transistor (T2) of the transistor pair (T1, T2).

5. System according to Claim 4,
**characterized in that**
the supply-voltage switchover device (SW) is designed to apply the second supply voltage (VPP) to the transistors of the transistor pair (T1, T2) only when and as long as a supply voltage is actually present at the multifunction connection pin (Py) and it is greater than the first supply voltage (VDD) by a certain minimum amount.

6. System according to one of Claims 3 to 5,
**characterized in that**
the wells containing the transistors of the transistor pair (T1, T2) are placed at the drain potential of the respective transistors.

7. System according to one of Claims 3 to 6,
**characterized in that**
a capacitor (C) is provided between the source connection and drain connection of the second transistor (T2) of the transistor pair (T1, T2).

8. System according to one of Claims 3 to 7,
**characterized in that**
a NIMOS is provided in parallel with the source/bulk diode of the first transistor (T1) of the transistor pair (T1, T2).

9. System according to one of the preceding claims,
**characterized in that**
the selected circuit parts to which optionally the first supply voltage (VDD) or the second supply voltage (VPP) can be supplied, include a programmable memory that can be read out using the first supply voltage and can be programmed using the second supply voltage.

## Revendications

1. Système composé d'un circuit intégré, d'un dispositif délivrant une première tension d'alimentation (VDD) et d'un dispositif délivrant une deuxième tension d'alimentation (VPP),
avec lequel le circuit intégré
- présente une première broche (Px) prévue pour l'application de la première tension d'alimentation (VDD),
- présente une deuxième broche (Py) prévue pour l'application de la deuxième tension d'alimentation (VPP),
- présente un dispositif de basculement de la tension d'alimentation (SW) par le biais duquel la première tension d'alimentation (VDD) ou la deuxième tension d'alimentation (VPP), au choix, peut être acheminée à certaines parties, à savoir uniquement à certaines parties du circuit intégré,
**caractérisé en ce**
- **que** la première tension d'alimentation (VDD) est la tension d'alimentation normale qui est acheminée en permanence au circuit intégré pendant le fonctionnement normal,
- **que** la deuxième tension d'alimentation (VPP) est une tension d'alimentation qui est supérieure à la première tension d'alimentation (VDD) et n'est appliquée que temporairement en plus de la première tension d'alimentation (VDD) et
- **que** le dispositif de basculement de la tension d'alimentation (SW) est conçu pour laisser passer automatiquement la deuxième tension d'alimentation (VPP) lorsque et tant que celle-ci est supérieure d'une certaine valeur minimale à la première tension d'alimentation (VDD).

2. Système selon la revendication 1, **caractérisé en ce que** le circuit intégré présente pour l'application de la deuxième tension d'alimentation (VPP) une broche de raccordement multifonctions (Py) qui, lorsque et tant qu'aucune deuxième tension d'alimentation n'est appliquée, peut être utilisée pour l'entrée et/ou la sortie d'autres signaux.

3. Système selon l'une des revendications précédentes, **caractérisé en ce que** le dispositif de basculement de la tension d'alimentation (SW) contient une paire de transistors (T1, T2) branchés en croix, transistors parmi lesquels le transistor dont la source est exposée à la tension la plus élevée laisse passer cette tension la plus élevée et le transistor dont la source est exposée à la tension la plus basse est bloqué.

4. Système selon la revendication 3, **caractérisé en ce qu'**un transistor (T1) de la paire de transistors (T1, T2) est exposé par sa source à la première tension d'alimentation (VDD) et par sa gâchette à la deuxième tension d'alimentation (VPP) et que le deuxième transistor (T2) de la paire de transistors (T1, T2) est exposé par sa source à la deuxième tension d'alimentation (VPP) et par sa gâchette à la première tension d'alimentation (VDD).

5. Système selon la revendication 4, **caractérisé en ce que** le dispositif de basculement de la tension d'alimentation (SW) est conçu pour n'appliquer la deuxième tension d'alimentation (VPP) aux transistors de la paire de transistors (T1, T2) que lorsque et tant qu'une tension d'alimentation est effectivement présente sur la broche de raccordement multifonctions (Py) et que celle-ci est supérieure d'une certaine valeur minimale à la première tension d'alimentation (VDD).

6. Système selon l'une des revendications 3 à 5, **caractérisé en ce que** les boîtiers contenant les transistors de la paire de transistors (T1, T2) sont mis au potentiel de drain des transistors respectifs.

7. Système selon l'une des revendications 3 à 6, **caractérisé en ce qu'**un condensateur (C) est prévu entre la borne de source et la borne de drain du deuxième transistor (T2) de la paire de transistors (T1, T2).

8. Système selon l'une des revendications 3 à 7, **caractérisé en ce qu'**un NIMOS est prévu en parallèle avec la diode de source/substrat du premier transistor (T1) de la paire de transistors (T1, T2).

9. Système selon l'une des revendications précédentes, **caractérisé en ce que** les parties choisies du circuit auxquelles peut être acheminée la première tension d'alimentation (VDD) ou la deuxième tension d'alimentation (VPP), au choix, comprennent une mémoire programmable qui peut être lue en utilisant la première tension d'alimentation et qui peut être programmée en utilisant la deuxième tension d'alimentation.
